# EUROPÄISCHE PATENTANMELDUNG

(11) **EP 1 279 968 A2**
(43) Veröffentlichungstag der Anmeldung: **29.01.2003**
(21) Anmeldenummer: 02100495.7
(22) Anmeldetag: 15.05.2002
(51) Int. Cl.: G01R 33/34, G01R 33/36

(54) **Sende- und Empfangsspule für MR-Gerät**

(30) Priorität: 19.05.2001 DE 10124465
(71) Anmelder: Philips Corporate Intellectual Property GmbH, 20099 Hamburg (DE); Koninklijke Philips Electronics N.V., 5621 BA Eindhoven (NL)
(72) Erfinder: Leussler, Christoph, 52066, Aachen (DE)
(74) Vertreter: Volmer, Georg, Dipl.-Ing.

(57) **Zusammenfassung**

Die Erfindung betrifft eine Anordnung zur Erzeugung von Hochfrequenzfeldern im Untersuchungsvolumen (100) eines MR-Gerätes. Um das Untersuchungsvolumen (100) herum sind innerhalb des Gradientenrohres (103) eine Mehrzahl von Resonatorsegmenten angeordnet, die zu einer Körperspule zusammengschaltet sind. Jedes Resonatorsegment weist ein als flächenhafter Streifen ausgebildetes Leiterelement (104) auf, das parallel zur Längsachse des Hauptfeldmagneten verläuft. Die Resonatorsegmente sind voneinander mittels zwischengeschalteter Kapazitäten elektromagnetisch entkoppelt, so dass jedem Resonatorsegment ein separater Sendekanal (1-8) zugeordnet werden kann, über welchen die HF-Einspeisung in das betreffende Resonatorsegment erfolgt. Dadurch dass für jedes Resonatorsegment die Phase und die Amplitude der HF-Einspeisung individuell vorgebbar sind, ermöglicht die erfindungsgemäße Anordnung eine nahezu vollständige Kontrolle der Hochfrequenz-Feldverteilung im Untersuchungsvolumen (RF-Shimming).

## Beschreibung

Die Erfindung betrifft eine Anordnung zur Erzeugung von Hochfrequenzfddern im Unteisuchungsvolumen eines MR-Gerätes, mit einer aus einer Mehrzahl von Resonatorsegmenten bestehenden Körperspule, wobei die Resonatorsegmente um das Untersuchung volumen herum angeordnet sind und jeweils aus wenigstens einem parallel zur Längsachse eines Hauptfeldmagneten verlaufenden Leiterelement und wenigstens einem Kondensatorelement bestehen.

Außerdem betrifft die Erfindung ein MR-Gerät mit einer Anordnung zur Erzeugung von Hochfrequenzfeldern gemäß der Erfindung

Zum Hochfrequenzsystem üblicher MR-Geräte gehört eine Sende- und Empfangsspule, wie zum Beispiel eine integrierte Körperspule (body coil), die für die Volumenbildgebung des Untersuchungsvolumens nutzbar ist. Zur Erzielung einer verbesserten Empfangsqualität (verbesserter Rauschabstand, höhere Auflösung) können auch gesonderte Oberflächenspulen oder sogenannte Phased-Array-Spulen verwendet werden. Bei den sowohl zur Anregung als auch zur Detektion von MR-Signalen verwendeten Körperspulen handelt es sich üblicherweise um sogenannte Käfig-Resonatoren (birdcage coil). Diese bestehen aus einer Mehrzahl von um das Unteisuchungsvolumen herum angeordneten und parallel zur Hauptfeldrichtung verlaufenden Leiterstäben, welche an den Stirnseiten der Spule über Ringleiter miteinander verbunden sind Das Resonanzverhalten der Körperspule wird durch Kondensatorelemente bestimmt, durch welche die Leiterelemente zu einem Netzwerk verschaltet sind. Die erste Resonanzmode (Grundmode) dieser Resonatoren zeichnet sich durch eine im gesamten Innenbereich des Resonators homogene B₁-Feldverteilung aus Entsprechendes gilt für das räumliche Empfindlichkeitsprofil bei der Detektion. Aus diesem Grund wird die Körperspule bei der Volumenbildgebung üblicherweise im Sende- und Empfangsbetrieb in der Grundmode betrieben. Möglich ist es auch, den Resonator derart anzusteuern, dass bei der gleichen Frequenz orthogonale, das heißt entkoppelte Resonanzen angeregt wsrden, was für die Quadraturdetektion ausgenutzt wird.

Bei der MR-Bildgsbung erfolgt die Lokalisierung der Kernmagnetisierung innerhalb des Untersuchungsvolumens mittels zeitlich veränderlicher räumlich inhomogener Magnetfelder (Magnetfeldgradienten). Zur Bilderzeugung wird das Kernspinsignal als Spannung, die in der das Untersuchungsvolumen umgebenden Körperspule induziert wird, unter dem Einfluss einer geeigneten Abfolge (Sequenz) von Hochfrequenz- und Gradientenpulse in der Zeitdomäne aufgezeichnet. Die eigentliche Bildrekonstruktion erfolgt dann durch Fouriertransformation der Zeitsignale. Durch die Zahl, den zeitlichen Abstand, die Dauer und die Stärke der verwendeten Gradientenpulse ist die Abtastung des reziproken k-Raumes vorgegeben, durch welchen der abzubildende Volumenbeteich (FOV, "field of view") sowie die Bildauflösung bestimmt sind Durch Anforderungen an die Bildgröße und Bildauflösung wird die Zahl der Phasenkodierungsschritte und damit die Dauer der Bildgebungssequenz vorgegeben. Bei modernen MR-Geräten wird eine Bilderzeugung mit möglichst hoher Auflösung in möglichst kurzer Zeit angestrebt. Dadurch ergeben sich besondere Anforderungen an das Gradientensystem der MR-Geräte, wodurch ein möglichst schnelles Schalten von möglichst starken Magnetfeldgradienten erreicht werden soll.

Bei MR-Geräten ist das Gradientensystem üblicherweise in einem sogsnannten Gradientenrohr untergsbracht, welches das Unteisuchungsvolumen umgibt. Zwischen Gradientenrohr und Körpeispule ist eine Hochfrequenzabschirmung (HF-Schirm) angaordnet, durch die einerseits Störsignale aus der Umgebung des Untersuchungsvolumens abgehalten und andererseits Abstrahlung von Hochfrequenzleistung in die Umgebung des MR-Gerätes verhindert wird. Eine Erhöhung der Gradientenfeldstärke kann beispielsweise durch Reduzierung des Durchmessers des Gradientenrohres erreicht werden. Bleibt dabei das Untersuchungsvolumen und der Innendurchmesser der Körperspule erhalten, so resultiert gleichzeitig eine Reduzierung des Abstandes zwischen Hochfrequenzabschirmung und Körperspule. Durch den geringen Abstand der Leiterelemente der Körperspule zu der Hochfrequenzabschirmung ergibt sich nachteiligerweise eine Reduzierung der B₁-Feldstärke beziehungsweise der Detektionsempfindlichkeit im Innenbereich der Spule. Dies hat unerwünschterweise zur Folge, dass die benötigte Sendeleistung ansteigt und gleichzeitig der Rauschabstand abfällt. Die Reduzierung des Rohrdurchmessers wirkt sich ferner nachteilig auf das Resonanzverhalten der Körperspule aus, da die Frequenzabstände zwischen den einzelnen Resonanzmoden zu klein werden, wodurch eine unerwünschte Modenkopplung entsteht. Aus den genannten Gründen sind bei Verwendung von herkömmlichen Käfig-Resonatoren als Sende- und Empfangsspule der Vergrößerung der Gradientenfeldstärke durch Reduzierung des Rohrdurchmessers Grenzen gesetzt.

Alternativ kann eine Erhöhung der Gradientenfeldstärke durch Verwendung eines Gradientenrohres mit asymmetrischem Querschnitt en-eicht werden. Dies macht jedoch auch den Einsatz von asymmetrischen Körperspulen erforderlich. Derartige asymmetrische Resonatoranordnungen führen in der Praxis zu einer Reihe von Problemen. Einerseits ist es schwierig, eine solche Körperspule zu orthogonalisieren, um einen Quadraturbetrieb möglich zu machen. Andererseits ist der Hochfrequenz-Feldverlauf im Spuleninneren von der Stromverteilung in der Anordnung der Leiterelemente abhängig, weswegen in der Regel bei asymmetrischen Resonatoren die Homogsnität des Hochfrequenzfeldes im Sendebetrieb und entsprechend des räumlichen Empfindlichkeitsprofils im Empfangsbetrieb nicht zufriedenstellend ist.

Von Leussler et al. wurde ein Käfig-Resonator vorgeschlagen, welcher in einer entarteten Resonanzmode betrieben wird, in der die räumlich benachbarten Segmente des Resonators entkoppelt sind, das heißt unabhängig voneinander schwingen (vgl. Leussler et al., Proceedings of the ISMRM, No. 176, Vancouver 1997). Bei der vorbekannten Spule wird das ausgenutzte Resonanzverhalten durch geeignete Wahl der Kondensatorelemente erzielt. Leider gelingt auf diese Weise lediglich die Entkopplung direkt benachbarter Resonatorsegmente. Die Kopplung zwischen entfernteren Segmenten ist zu hoch, so dass ein Betrieb der Spule im resonanten Sendebetrieb nicht möglich ist.

Ausgehend von dem angsführten Stand der Technik liegt der vorliegenden Erfindung die Aufgabe zugrunde, eine verbesserte HF-Sende- und -Empfangsanordnung für MR-Geräte bereitzustellen, welche für beliebige, insbesondere auch für kleine und asymmetrische Rohrdurchmesser einsetzbar ist. Dabei soll gleichzeitig eine ausreichende Homogenität und ein gut handhabbares Resonanzverhalten gegeben sein.

Diese Aufgabe wird ausgehend von einer Anordnung der eingangs genannten Art dadurch gelöst, dass die Resonatorsegmente voneinander elektromagnetisch entkoppelt sind und dass jedem Resonatorsegment ein separater Sendekanal zugeordnet ist, über welchen die HF-Einspeisung in das betreffende Resonatorsegment erfolgt, wobei für jedes Resonatorsegment die Phase und/oder die Amplitude der HF-Einspeisung individuell vorgebbar sind.

Dadurch dass jedem Resonatorsegment ein separater Sendekanal zugeordnet ist, ist die Feldverteilung im Untersuchungsvolumen vorteilhafterweise vollständig kontrollierbar. Es ist nämlich möglich, jede erdenkliche Stromverteilung in der Anordnung der Leiterelemente durch Vorgabe von Amplitude und Phase auf den einzelnen Sendekanälen zu erzeugen. Auch der zeitliche Verlauf der HF-Einspeisung kann auf jedem Sendekanal individuell unterschiedlich vorgegeben werden. Dabei besteht insbesondere die Möglichkeit, die Feldverteilung eines herkömmlichen Käfig-Resonators mit gleicher Anzahl von Resonatorsegmenten in jeder beliebigen Resonanzmode nachzubilden. Die Amplitude und die Phase jedes einzelnen Sendekanals kann durch die Software des MR-Gerätes kontrolliert werden, was eine direkte interaktive Steuerung der Feldverteilung (RF-Shimming) möglich macht. Denkbar ist es beispielsweise, eine vollautomatische Regelung der HF-Feldhomogenität in die Bildgebungssequenz zu integrieren, um veränderliche Einflüsse auf die Feldverteilung, wie beispielsweise durch die unterschiedlichen dieleldrischen Eigenschaften der untersuchten Patienten, zu kompensieren.

Bei der erfindungsgemäßen Anordnung zur Erzeugung von Hochfrequenzfeldern ist lediglich Voraussetzung, dass die einzelnen Resonatorsegmente voneinander elektromagnetisch entkoppelt sind Die Körperspule muss also ein Resonanzverhalten aufweisen, bei dem sichergestellt ist, dass die einzelnen Resonatorsegmente bei der gewünschten Resonanzfrequenz unabhängig voneinander schwingen. Es sind, wie oben beschrieben, Spulenanordnungen bekannt, bei denen zumindest unmittelbar benachbarte Resonatorsegmente voneinander entkoppelt sind Bei der Anordnung gemäss der Erfindung müssen zusätzliche Mittel vorgesehen werden, durch welche die elektromagnetischen Kopplungen auch zwischen räumlich entfernteren Resonatorsegmenten minimiert werden. In der Praxis hat es sich gezeigt, dass eine gegenseitige Isolation der Resonatorsegmente von etwa -20 dB wünschenswert ist, um ein Übersprechen zwischen den einzelnen Sendekanälen soweit wie möglich zu verhindern.

Die gegenseitige elektromagnetische Entkopplung der Resonatorsegmente kann besonders einfach gemäß Anspruch 2 mittels zwischen den Leiterelementen angeordneter Kapazitäten oder Induktivitäten erfolgen. Durch geeignete Bemessung der Kapazitäts- beziehungsweise Induktivitätswerte muss sichergestellt werden, dass keine resonante Kopplung zwischen den unterschiedlichen Resonatorsegmenten besteht. Es kann dabei sinnvoll sein, Entkopplungsnetzwerke (bestehend ais Kapazitäten und Induktivitäten) zwischen den Leiterelementen sowohl benachbarter als auch entfernterer Resonatorsegmente vorzusehen.

Eine besonders vorteilhafte Ausgestaltung der erfindungsgemäßen Anordnung ergibt sich, wenn gemäß Anspruch 3 die Leiterelemente als im wesentlichen rechteckige, flächenhafte Streifen ausgsbildet sind. Es zeigt sich, dass bei der Verwendung von flachen Leiterstreifen die magnetischen Kopplungen zwischen entfernteren Resonatorsegmenten abgeschwächt sind. Zudem lässt sich mittels der flachen Leiterstreifen die Körperspule besonders platzsparend realisieren. Weiterhin ist die Stromverteilung innerhalb der streifenförmigen Leiterelemente leicht beeinflussbar, indem beispielsweise Löcher oder Ausfräsungen eingebracht oder die Kanten der Leiterstreifen geeignet strukturiert werden. Die Verwendung von flachen Leiterstreifen führt zu einer ebenfalls flächenhaften Stromverteilung innerhalb der Leiterelemente, wodurch eine verbesserte lokale Feldhomogenität erreicht wird.

Durch den HF-Schirm, der sich zwischen Gradientenrohr und Körperspule befindet, wird die Feldstärke im Untersuchungsvolumen abgeschwächt, weswegen üblicherweise ein möglichst großer Abstand zwischen Spulenanordnung und HF-Schirm eingähalten werden muss. Demgegenüber ist es jedoch bei der erfindungsgemäßen Anordnung zweckmäßig, die Leiterelemente der einzelnen Resonatorsegmente gemäß Anspruch 6 mit geringem Abstand zu dem HF-Schirm anzuordnen. Durch die Nähe zu dem HF-Schirm wird nämlich die gegenseitige magnetische Kopplung zwischen den einzelnen Leiterelementen herabgesetzt, was für das Resonanzverhalten der Körperspule im Sinne der Erfindung vorteilhaft ist. Es kann zweckmäßig sein, den Abstand zwischen den Leiterelementen und dem HF-Schirm derart zu wählen, dass einerseits eine ausreichende magnetische Entkopplung zwischen den Leiterelementen erreicht wird und dass außerdem die Hochfrequenzfeldstärke im Untersuchungsvolumen nicht zu weit herabgesetzt ist. In Experimenten hat es sich als vorteilhaft erwiesen, zwischen Resonatorsegment und HF-Schirm einen Abstand von 0,5 bis 2 cm, am besten jedoch 0,7 bis 1,5 cm, vorzusehen.

Durch die Möglichkeit, mit der erfindungsgemäßen Anordnung die räumliche Verteilung des Hochfrequenzfeldes im Untersuchungsvolumen beliebig vorgeben zu können, erschließen sich eine Reihe von weiteren Anwendungsfeldern. So lassen sich beispielsweise Gradienten im Hochfrequenzfeld in verschiedenen Raumrichtungen erzeugen. Durch die Vorgabe von räumlich und zeitlich variablen Hochfrequenz-Feldmustern kann der angeregten Kernmagnetisierungsverteilung eine Ortscodierung aufgeprägt werden, die für eine schnelle Volumenbildgebung nutzbar ist (Transmit-SENSE-Methode). Denkbar ist außerdem eine räumlich selektive Vorsättigung der Kernmagnetisierung im Untersuchungsvolumen.

Eine besonders vorteilhafte Ausgestaltung ergibt sich gemäß Anspruch 7, wenn bei der erfindungsgemäßen Anordnung die Körperspule in wenigstens zwei unabhängige, in axialer Richtung hintereinander angeordnete Abschnitte unterteilt ist. In diesem Fall besteht die Möglichkeit, auch in der Hauptfeldrichtung (z-Richtung) die Hochfrequenz-Feldverteilung variabel vorgeben zu können, wobei insbesondere Hochfrequenz-Feldgradienten entlang der z-Achse möglich sind

Ferner ist es zweckmäßig, gemäß Anspruch 8 jedem Resonatorsegment einen separaten Empfangskanal zuzuordnen, über welchen die mittels den betreffenden Resonatorsegmenten detektierten MR-Signale an eine Empfangseinheit zur Weiterverarbeitung übertragen werden Es besteht damit einerseits die Möglichkeit, durch Kombination der mittels der einzelnen Resonatorsegmente detektierten MR-Signale eine Volumenbildgebung mit räumlich homogenem Empfindlichkeitsprofil durchzuführen. Alternativ können aus den getrennt detektierten MR-Signalen Teilbilder erzeugt werden, die dann nachträglich zu einem Gesamtbild miteinander kombiniert werden. Dies kann einerseits zur Verbesserung des Rauschabstandes vorteilhaft sein, wobei die einzelnen Resonatorsegmente als Synergie-Spulen eingesetzt werden. Auch besteht die Möglichkeit, die Einzelbilder unter Zugrundelegung der den einzelnen Resonatorsegmenten zugeordneten räumlichen Empfindlichkeitsprofile miteinander zu kombinieren, um bei der Bildgebung Messzeit einzusparen (SENSE-Methode).

Die erfindungsgemäße Anordnung erlaubt es vorteilhafterweise, dass das Untersuchungsvolumen in der senkrecht zur Hauptfeldrichtung verlaufenden Ebene einen asymmetrischen Querschnitt hat, an dessen Umfangsrand die Leitetelemente der einzelnen Resonator-Segmente angeordnet sind. Dadurch dass die Hochfrequenz-Feldverteilung im Unteisuchungsvolumen nahezu beliebig steuerbar ist, kann auch bei einer derartigen asymmetrischen Geometrie der Körperspule eine hinreichende Homogenität sowohl des Anregungsfeldes als auch des räumlichen Empfindlichkeitsprofils bei der Detektion sichergestellt werden. Wie erwähnt haben asymmetrische Untersuchungsvolumina den Vorteil, dass sich besonders hohe Magnetfeldgradienten erzielen lassen.

Die erfindungsgemäße Anordnung zur Erzeugung von Hochfrequenzfeldern kann bei einem MR-Gerät gemäß Anspruch 10 zum Einsatz kommen. Eine besonders einfach Realisierung ergibt sich gemäß Anspruch 11, wonach nämlich jeder Sendekanal an einen dem betreffenden Resonatorsegment zugeordneten Ausgang eines Verbindungsnetzwerkes (Combiner-Hybrid) angeschlossen ist, durch welches die Leistung eines Sendeverstärkers auf die einzelnen Resonatorsegmente verteilt wird. Dabei wird durch das Verbindungsnetzwerk für jedes Resonatorsegment die Phase und die Amplitude des jeweils eingespeisten HF-Signals festgelegt. Diese Ausführung hat den Vorteil, dass lediglich ein einziger Leistungssender für die Hochfrequenzeinstrahlung benötigt wird, dessen Ausgangssignal mittels des Combiner-Hybrids auf die einzelnen Resonatorsegmente verteilt wird. Dabei erfolgt die Verteilung zweckmäßigerweise derart, dass im Untersuchungsvolumen eine möglichst homogene Hochfrequenz-Feldverteilung erzeugt wird. Zweckmäßig ist es, wenn gemäß Anspruch 12 wenigstens einem, möglichst aber jedem Resonatorsegment ein Messelement (Pick-Up Spule) zugeordnet ist, über welches die von dem jeweilgen Resonatorsegment abgestrahlte HF-Feldstärke ermittelt wird, wobei das Messsignal der Steuerungseinheit des MR-Gerätes zur Überwachung und/oder zur Regelung der Phase und der Amplitude des eingespeisten HF-Signals zugeführt wird.

Ausführungsbeispiele der Erfindung werden im folgenden anhand der Figuren erläutert. Es zeigen:
Fig 1 MR-Gerät mit erfindungsgemäßer Sende- und Empfangsanordnung;
Fig. 2 erfindungsgemäße Verwendung eines entkoppelten Käfigresonators;
Fig. 3 ebene Darstellung einer erfindungsgemäßen Körperspule;
Fig. 4 alternative Ausführungsform einer erfindungsgemäßen Körpeispule;
Fig. 5 weitere Ausführungsform einer erfindungsgemäßen Körperspule;
Fig. 6 verschieden strukturierte streifenförmige Leiterelemente;
Fig. 7 Entkopplung von Leiterelementen;
Fig. 8 ebene Darstellung einer in zwei unabhängige, hintereinander angeordnete Abschnitte unterteilten Körperspule

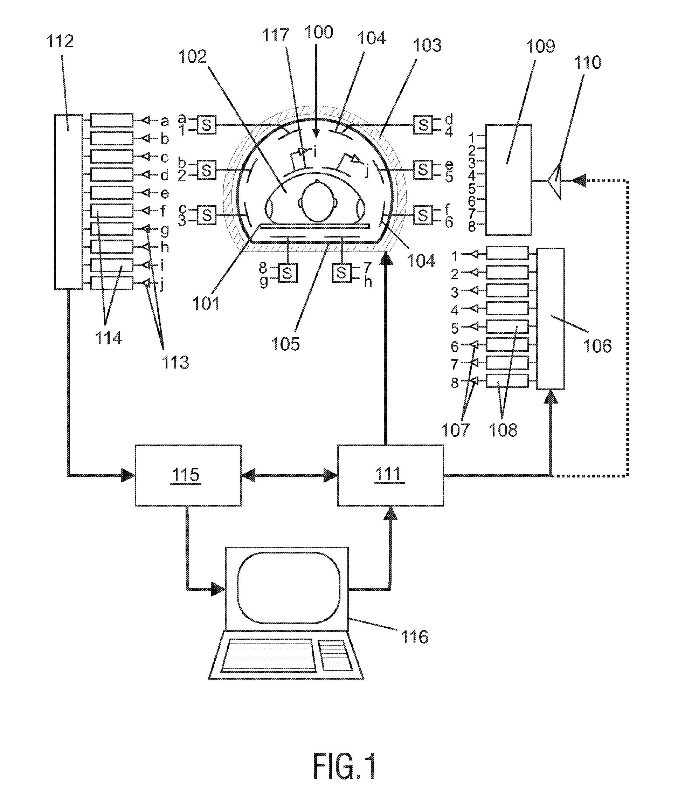

Im Zentrum des in der Figur 1 dargestellten MR-Gerätes steht ein Untersuchungsvolumen 100, in dem sich auf einem Patiententisch 101 ein Patient 102 befindet. Im Bereich des Untersuchungsvolumens 100 wird ein statisches Magnetfeld mit einer Stärke von beispielsweise 1.5 Tesla mittels eines nicht näher dargestellten Hauptfeldmagneten erzeugt. Für die MR-Bildgebung müssen im Untersuchungsvolumen 100 außerdem zeitlich veränderliche Magnetfeldgradienten erzeugt werden. Hierzu dienen mehrere Gradientenspulen, die in einem das Untersuchungsvolumen 100 umgebenden Gradientenrohr 103 untergebracht sind. Das Gradientenrohr 103 weist einen asymmetrischen Querschnitt auf, was, wie oben beschrieben, für die Erreichung von möglichst großen Gradientenfeldstärken förderlich ist. Die für die MR-Bildgebung ferner erforderliche Erzeugung von Hochfrequenzfeldern erfolgt mittels innerhalb des Gradientenrohres 103 um das Untersuchungsvolumen 100 herum angaordneter Resonatorsegmente, die aus parallel zur Längsachse des Hauptfeldmagneten verlaufenden flachen, streifenförmigen Leiterelementen 104 bestehen. Die Leiterelemente 104 sind untereinander und gegebenenfalls auch gegen Masse über Kondensatorelemente vernetzt, wodurch das Resonanzverhalten der Anordnung bestimmt wird. Die Kondensatorelemente bilden zusammen mit den Leiterelementen 104 die Körperspule des MR-Gerätes, welche außer zur Anregung von Kernresonanzsignalen im Untersuchungsvolumen 100 auch zu deren Detektion verwendet wird. Zwischen dem Gradientenrohr 103 und den Leiterelementen 104 der Körperspule befindet sich ein das gesamte Untersuchungsvolumen 100 umgebender HF-Schirm 105. Durch diesen werden Störsignale aus der Umgebung des MR-Gerätes abgehalten und außerdem wird die Hochfrequenz-Abstrahlung in die Umgebung unterdrückt. Jedes der in der Figur 1 dargestellten acht Leiterelemente 104 steht mit einem Umschalter S in Verbindung, durch den das betreffende Leiterelement 104 je nach Betriebsmodus mit einem von zwei möglichen Anschlüssen verbunden wird. Die für den Sendebetrieb bestimmten Anschlüsse sind mit den Ziffern 1-8, die für den Empfangsbetrieb vorgesehenen Anschlüsse mit den Kleinbuchstaben a-h bezeichnet. Den Anschlüssen 1-8 sind die mit den entsprechenden Ziffern versehenen Ausgänge einer Sendeeinheit 106 zugeordnet. Diese hat für jedes einzelne Resonatorsegment der Körpeispule einen eigenen Sendekanal, welcher jeweils einen Leistungsverstärker 107 sowie eine Hochfrequenz-Steuereinheit 108 aufweist. Mittels der Hochfrequenz-Steuereinheit 108 ist die Amplitude und die Phase des Hochfrequenzsignals für jeden einzelnen Sendekanal individuell einstellbar, so dass nahezu jede beliebige Hochfrequenz-Feldverteilung im Untersuchungsvolumen 100 des MR-Gerätes erzeugt werden kann. Als weniger aufwendige Alternative ist es auch möglich, ein Verteilungsnetzwerk 109 (Combiner-Hybrid) zu verwenden, durch welches das Ausgangssignal eines Hochfrequenz-Sendeverstärkers 110 auf die Anschlüsse 1-8 verteilt wird, wobei durch das Combiner-Hybrid für jeden Ausgangskanal 1-8 die Amplitude und Phase des Hochfrequenzsignals festgelegt wird. Zur Erzeugung von Hochfrequenzpulsen im Untersuchungsvolumen 100 steht die Sendeeinheit 106 beziehungsweise der Sendeverstärker 110 mit einer Steuerungseinheit 111 in Verbindung Zur Kontrolle der zeitlichen Abfolgs der Gradientenpulse ist die Steuerungseinheit 111 außerdem mit dem Gradientenrohr 103 verbunden. Den für den Empfangsbetrieb bestimmten Anschlüssen a-h sind mit den entsprechenden Buchstaben bezeichnete Empfangskanäle einer Empfangseinheit 112 zugeordnet. Jeder Empfangskanal ist mit einem empfindlichen Hochfrequenz-Vorverstärker 113 sowie mit einem Demodulator 114 ausgestattet. Die von der Empfangseinheit 112 registrierten MR-Signale werden an eine Rekonstruktionseinheit 115 übertragen, wo die digitalisierten Signale miteinander kombiniert und Fourier-analysiert werden. Die mittels der Rekonstruktionseinheit 115 generierten Bilder werden dann auf dem Monitor eines Mikrocomputers 116 ausgegeben. Der Mikrocomputer 116 dient gleichzeitig der Steuerung des MR-Gerätes durch einen Benutzer, wozu der Computer 116 außerdem mit der Steuerungseinheit 111 in Verbindung steht. Bei der Bildgebung können außerdem direkt auf dem Körper des Patienten 102 aufliegende Oberflächenspulen 117 zum Einsatz kommen, welche über die Anschlüsse i und j mit den entsprechenden Eingängen der Empfangseinheit 112 verbunden sind. Die Oberflächenspulen 117 sind beispielsweise für die lokale Herzbildgebung einsetzbar, wobei die im Rückenbereich des Patienten 102 angeordneten Leiterelemente 104 der Körperspule (Anschlüsse g und h) zusammen mit den Oberflächenspulen 117 im Synergiebetrieb für die Datenakquisition verwendet werden.

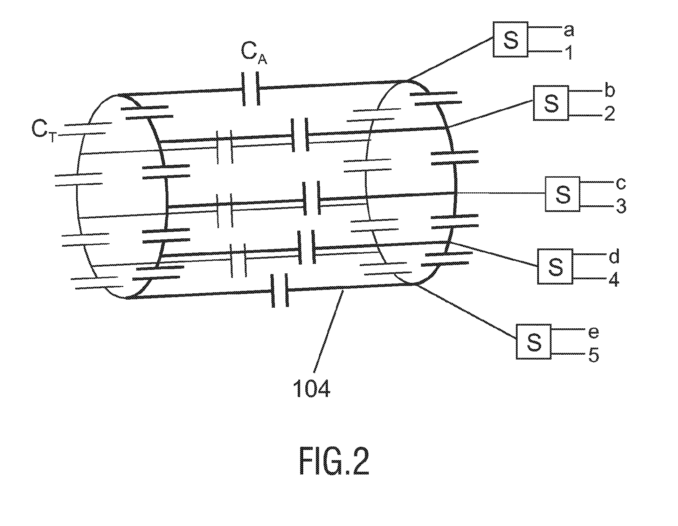

Die Figur 2 zeigt einen herkömmlichen Käfig-Resonator, bei dem die Ringkapazitäten C_{T} und die Stabkapazitäten C_{A} so gewählt sind, dass der Resonator bei der gewünschten Resonanzfrequenz in einer entkoppelten Mode arbeitet (vgl. Leussler et al., Proceedings of the ISMRM, No. 176, Vancouver 1997). Ein solcher Resonator kann mit beliebigem Durchmesser und beliebigem Querschnitt (symmetrisch oder asymmetrisch) gemäß der Erfindung eingesetzt werden. Aufgrund der speziellen Resonanzmode des Resonators sind, wie bereits erwähnt, die unmittelbar benachbarten Resonatorsegmente voneinander ausreichend entkoppelt. Für den resonanten Sendebetrieb sind die Kopplungen zwischen entfernteren Segmenten allerdings zu hoch. Um hier eine ausreichende Entkopplung (wenigstens -20 dB) zu erreichen, können die einzelnen Leiterstäbe 104 mittels geeigneter Impedanznetzwerke voneinander isoliert werden. Unter Umständen ist eine solche Entkopplung jeweils von übernächsten Nachbarn ausreichend. Förderlich ist es für die Entkopplung außerdem, einen vergleichsweise geringen Abstand zwischen Resonator und HF-Schirm zu wählen, auch wenn hierdurch die Hochfrequenz-Feldstärke im Untersuchungsvolumen geringfügig herabgesetzt wird. Bei dem Resonator, der in der Figur 2 nur schematisch gezeigt ist, können die parallel zur Hauptfeldrichtung verlaufenden Stäbe 104 auch als flache Leiterstreifen ausgebildet sein. Bei dieser Ausführung des Resonators, mit Kapazitäten in den Stäben bzw. Streifen, fließt aufgrund der galvanischen Trennung kein Strom über den HF-Schirm ab. Vorteilhaft kann es des weiteren sein, wenn der Resonator derart ausgebildet ist, dass sich der Abstand zwischen HF-Schirm und den Leiterstreifen 104 entlang deren Längserstreckung verändert, wobei der Abstand zum HF-Schirm an den stirnseitigen Enden des Resonators größer ist als im Zentralbereich. Hierdurch wird die Homogenität des RF-Feldes im Untersuchungsvolumen verbessert.

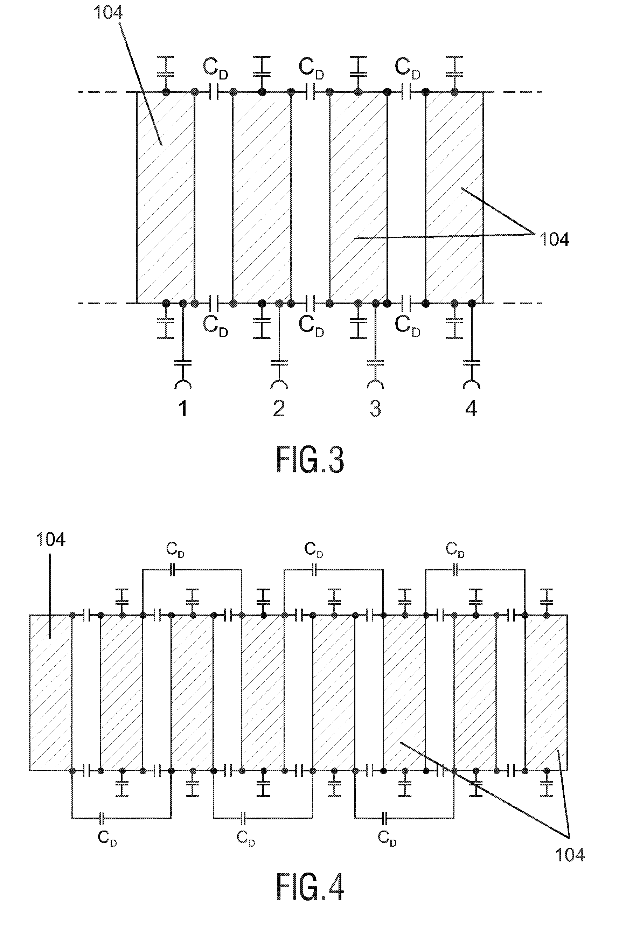

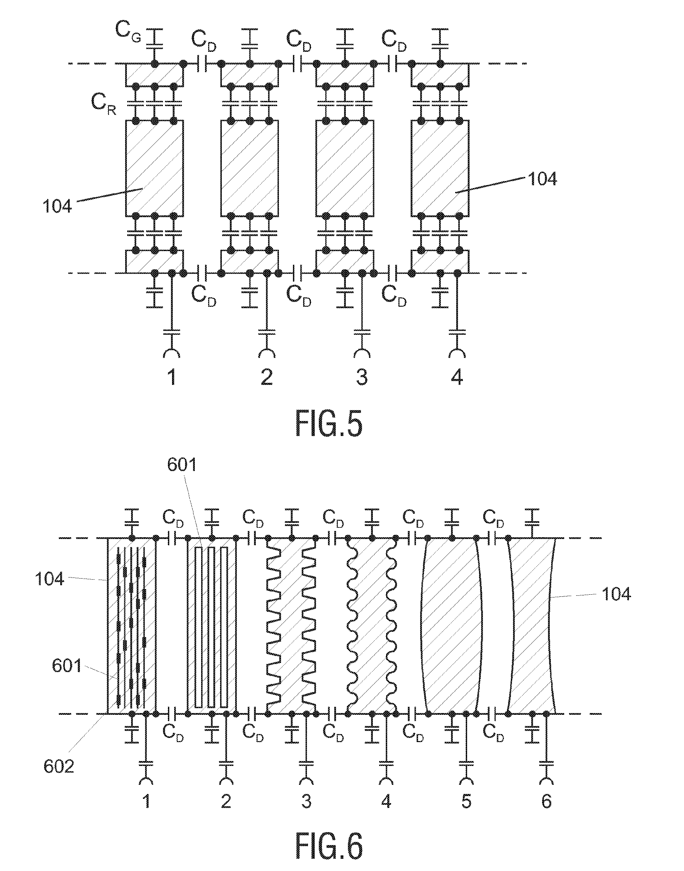

Die Figuren 3, 4 und 5 zeigen ebene Darstellungen von Körperspulen gemäß der Erfindung Die Spulen bestehen aus einer Mehrzahl von flachen Leiterstreifen 104, die um das Untersuchungsvolumen herum angeordnet sind. Durch die in den Figuren 3 und 4 jeweils gegen Masse geschalteten Kondensatoren wird die Resonanzfrequenz der einzelne Resonator-Segmente bestimmt. Bei der Körperspule gemäß Figur 5 wird die Resonanzfrequenz durch die in den Leiterstreifen angeordneten Kapazitäten C_{R} und die gegen Masse geschalteten Kapazitäten C_{G} bestimmt. Eine solche Anordnung ist besonders vorteilhaft, um bei hohen Resonanzfrequenzen elektromagnetische Ausbreitungseffekte zu vermeiden. Innerhalb der Leiterstreifen werden mehrere parallel geschaltete Kapazitäten C_{R} verwendet, um die hohen Stromstärken während des Sendebetriebs aufzuteilen und um eine gleichmäßige Stromverteilung zu erreichen, was für die Homogenität des Hochfrequenzfeldes vorteilhaft ist. Möglich ist es auch, die Kapazitäten C_{R} dadurch zu erhalten, dass zwischen den im Bereich der Kapazitäten C_{R} aufeinanderstoßenden Enden der Leiterstreifen 104 Überlappungen vorgesehen werden, wobei sich im Überlappungsbereich zwischen den Streifen ein dielektrisches Material mit möglichst hoher Dielektrizitätskonstante (z.B. Keramik) befindet. Auf ähnliche Weise kann auch die Kapazität zwischen Leiterstreifen 104 und HF-Schirm realisiert werden. Die zwischen den einzelnen Leiterelementen 104 angeordneten Kapazitäten C_{D} dienen zur gegenseitigen Entkopplung. Diese Entkopplung ist Voraussetzung dafür, dass die einzelnen Resonatorsegmente gemäß der Erfindung unabhängig voneinander durch separate Sendekanäle angesteuert werden können. Hierzu ist jedes einzelne Leiterelement 104 über einen zwischengeschalteten Kondensator mit einem Sendekanal 1, 2, 3 bzw. 4 verbunden (Fig 3, 5). Bei den in den Figuren 3 und 5 dargestellten Anordnungen befinden sich Entkopplungskapazitäten zwischen unmittelbar benachbarten Leiterstreifen 104. Die ausreichende Entkopplung entfernterer Resonatorsegmente muss durch andere Maßnahmen sichergestellt sein (Formgebung der Leiterelemente, räumlicher Abstand, Nähe zum HF-Schirm). Bei der in der Figur 4 dargestellten Körperspule sind auch die übernächsten Nachbarn durch zwischengeschaltete Kapazitäten C_{D} voneinander enthoppelt. Die Verbindung zwischen den entfernteren Leiterelementen erfolgt zweckmäßigerweise über koaxiale Kabel geeigneter Länge (λ/2). Zur Entkopplung sind statt Kapazitäten auch Induktivitäten (Spulen) einsetzbar.

Die Figur 6 zeigt verschiedene Ausführungen von Leiterstreifen 104, bei denen unterschiedliche Strukturierungen vorgssehen sind, um eine möglichst homogene Stromverteilung zu erzielen. Hierzu ist es insbesondere zweckmäßig, die Kantenimpedanz der Leiterstreifen durch eine der dargestellten sägezahnartigen Kantenstrukturierungen zu erhöhen. Denkbar sind auch konvexe oder konkave Ausführungen der Leiterstreifen 104 oder die Anbringung von Schlitzen 601, die durch Kondensatoren 602 überbrückt sein können.

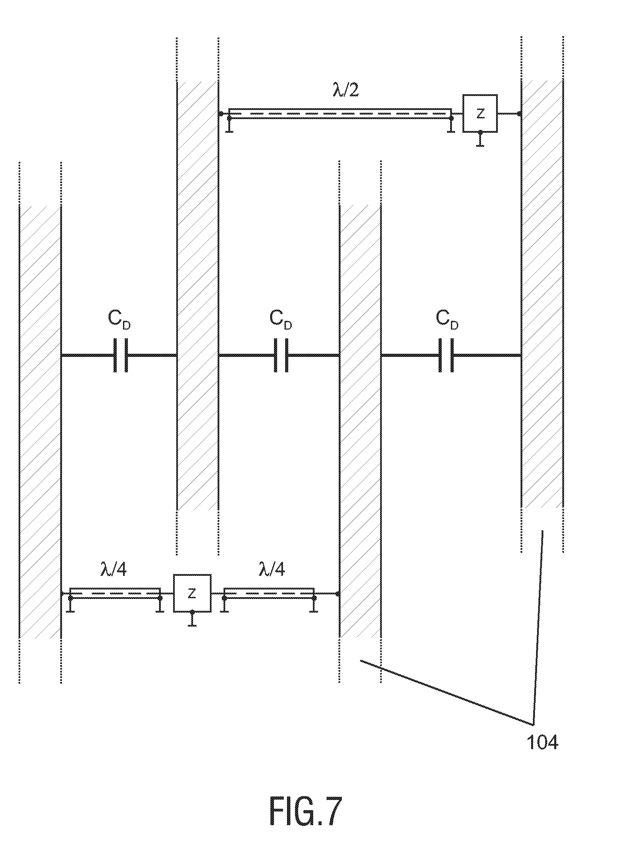

In der Figur 7 ist die Realisierung der gegenseitigen elektromagnetischen Entkopplung übernächster Resonatorsegmente 104 gezeigt. Da die entsprechenden Leiterstreifen 104 nicht unmittelbar nebeneinander liegen, werden diese mit Koaxialkabeln geeigneter Länge (λ/2 bzw. λ/4) verbunden. Ein geeignetes Impedanznetzwerk Z bewirkt dann die gewünschte Isolierung. Ziel ist es, dem jeweils anderen Resonatorsegment das Signal so über das Impedanznetzwerk Z zuzuführen, dass durch die geeignete Vorgabe der Amplitude und durch die entsprechende Verschiebung der Phase eine Kompensation des direkt eingekoppelten Hochfrequenzsignals erreicht wird. Eine solche Entkopplung ist selbstverständlich gleichermaßen auch für unmittelbar benachbarte und für entfernte Segmente des Resonators einsetzbar. Das Impedanznetzwerk Z kann im einfachsten Fall aus einem Kondensator, über den die betreffenden Resonatorsegmente in Verbindung stehen, oder aus einer gegen Masse geschalteten Induktivität bestehen.

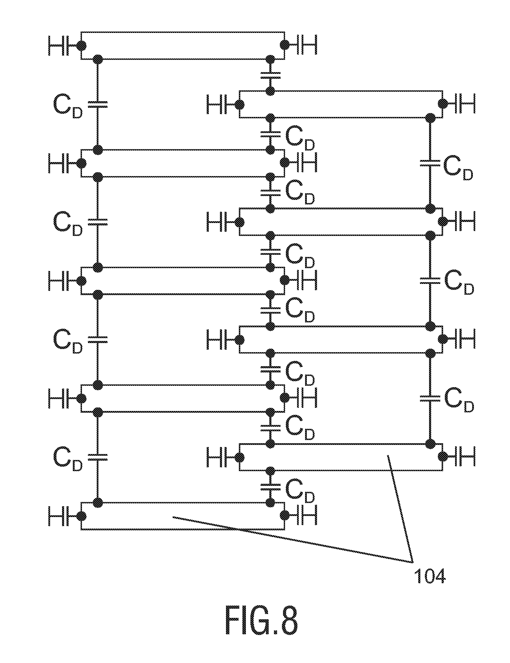

Die Figur 8 zeigt eine verschachtelte Hintereinanderanordnung von Leiterelementen, welche gsmäß der Erfindung durch zwischengsschaltete Kapazitäten C_{D} voneinander entkoppelt und zu einer Körperspule miteinander verschaltet sind Es stehen damit zwei unabhängige, in axialer Richtung hintereinander angeordnete Abschnitte der Körperspule zur Verfügung, was zur Steuerung der Hochfrequenz-Feldverteilung in der zur Längsachse des Hauptfeldmagneten parallelen Richtung (z-Richtung) ausgenutzt werden kann.

## Patentansprüche

1. Anordnung zur Erzeugung von Hochfrequenzfeldern im Untersuchungsvolumen (100) eines MR-Gerätes, mit einer aus einer Mehrzahl von Resonatorsegmenten bestehenden Körperspule, wobei die Resonatorsegmente um das Unteisuchungsvolumen (100) herum angeordnet sind und jeweils aus wenigstens einem parallel zur Längsachse eines Hauptfeldmagneten verlaufenden Leiterelement (104) und wenigstens einem Kondensatorelement bestehen,
**dadurch gekennzeichnet,**
**dass** die Resonatorsegmente voneinander elektromagnetisch entkoppelt sind und dass jedem Resonatorsegment ein separater Sendekanal (1-8) zugsordnet ist, über welchen die HF-Einspeisung in das betreffende Resonatorsegment erfolgt, wobei für jedes Resonatorsegment die Phase und/oder die Amplitude der HF-Einspeisung individuell vorgsbbar sind

2. Anordnung nach Anspruch 1,
**dadurch gekennzeichnet,**
**dass** die elektromagnetische Entkopplung der Resonatorsegmente mittels zwischen den Leiterelementen (104) angeordneter Kapazitäten (C_{D}) oder Induktivitäten erfolgt.

3. Anordnung nach Anspruch 1,
**dadurch gekennzeichnet,**
**dass** die Leiterelemente (104) als im wesentlichen rechteckige, flächenhafte Streifen ausgsbildet sind

4. Anordnung nach Anspruch 3,
**dadurch gekennzeichnet,**
**dass** die Kanten der Leiterstreifen eine sägezahnartige Strukturierung aufweisen.

5. Anordnung nach Anspruch 3,
**dadurch gekennzeichnet,**
**dass** auf den Flächen der Leiterstreifen parallel zu deren Längserstreckung verlaufende Schlitze angeordnet sind

6. Anordnung nach Anspruch 1,
**gekennzeichnet durch** einen um die Körperspule herum angeordneten HF-Schirm (105), wobei die Leiterelemente (104) der einzelnen Resonatorsegmente mit einem geringen Abstand von 0,5 bis 2 cm zu dem HF-Schirm (105) angeordnet sind

7. Anordnung nach Anspruch 1,
**dadurch gekennzeichnet,**
**dass** die Körperspule in wenigstens zwei unabhängige, in axialer Richtung hintereinander angeordnete Abschnitte unterteilt ist.

8. Anordnung nach Anspruch 1,
**dadurch gekennzeichnet,**
**dass** jedem Resonatorsegment ein separater Empfangskanal (a-h) zugeordnet ist, über welchen die mittels dem betreffenden Resonatorsegment detektierten MR-Signale an eine Empfangseinheit (112) zur Weiterverarbeitung übertragen werden.

9. Anordnung nach Anspruch 1,
**dadurch gekennzeichnet,**
**dass** das Untersuchungsvolumen (100) in der senkrecht zur Hauptfeldrichtung verlaufenden Ebene einen asymmetrischen Querschnitt hat, an dessen Umfangsrand die Leiterelemente (104) der einzelnen Resonatorsegmente angeordnet sind

10. MR-Gerät, mit einer Anordnung zur Erzeugung von Hochfrequenzfddern nach Anspruch 1, mit wenigstens einer Hauptfeldspule zur Erzeugung eines homogenen, statischen Magnetfeldes in einem Untersuchungsvolumen (100), einer Anzahl von Gradientenspulen zur Erzeugung von Gradientenpulsen in unterschiedlichen Raumrichtungen, einer aus einer Mehrzahl von Resonatorsegmenten bestehenden Körperspule, wobei die Resonatorsegmente um das Untersuchungsvolumen (100) herum angeordnet sind und jeweils aus wenigstens einem parallel zur Längsachse der Hauptfeldspule verlaufenden Leiterelement (104) und wenigstens einem Kondensatorelement bestehen, wenigstens einer Steuerungseinheit (111) für die Steuerung der zeitlichen Abfolgs von Hochfrequenz- und Gradientenpulsen und einer Rekonstruktions- (115) und Visualisierungseinheit (116),
**dadurch gekennzeichnet,**
**dass** die Resonatorsegmente der Körperspule voneinander elektromagnetisch entkoppelt sind, wobei jedem Resonatorsegment ein separater Sendekanal (1-8) zugaordnet ist, über welchen die HF-Einspeisung in das betreffende Resonatorsegment erfolgt, und wobei für jedes Resonatorsegment die Phase und/oder die Amplitude der HF-Einspeisung individuell vorgebbar sind, und
**dass** jedem Resonatorsegment ein separater Empfangskanal (a-h) zugeordnet ist, über welchen die mittels dem betreffenden Resonatorsegment detektierten MR-Signale an eine Empfangseinheit (112) zur Weiterverarbeitung mittels der Rekonstruktions- (115) und Visualisierungseinheit (116) übertragen werden.

11. MR-Gerät nach Anspruch 10,
**dadurch gekennzeichnet,**
**dass** jeder Sendekanal (1-8) an einen dem betreffenden Resonatorsegment zugeordneten Ausgang eines Verbindungsnetzwerkes (Combiner-Hybrid, 109) angeschlossen ist, durch welches die Leistung eines Sendeverstärkes (110) auf die einzelnen Resonatorsegmente verteilt wird, wobei durch das Verbindungsnetzwerk (109) für jedes Resonatorsegment die Phase und die Amplitude des jeweils eingespeisten HF-Signals festgelegt wird.

12. MR-Gerät nach Anspruch 10,
**dadurch gekennzeichnet,**
**dass** wenigstens einem Resonatorsegment ein Messelement (Pick-Up Spule) zugeordnet ist, über welches die von dem jeweilgen Resonatorsegment abgestrahlte HF-Feldstärke ermittelt wird, wobei das Messsignal der Steuerungseinheit (111) zur Überwachung und/oder zur Regelung der Phase und der Amplitude des eingespeisten HF-Signals zugeführt wird.
